Europäisches Patentamt

European Patent Office

Office européen des brevets

(11) Publication number: **0 224 314**
A2

# (12) EUROPEAN PATENT APPLICATION

(21) Application number: **86202091.4**

(22) Date of filing: **25.11.86**

(51) Int. Cl.⁴: **H 01 J 31/60**
**H 01 J 1/30, H 01 J 29/41**
**H 01 J 29/44**

(30) Priority: **29.11.85 GB 8529438**

(43) Date of publication of application:
**03.06.87 Bulletin 87/23**

(84) Designated Contracting States:
**DE FR GB IT SE**

(71) Applicant: **PHILIPS ELECTRONIC AND ASSOCIATED
INDUSTRIES LIMITED
Arundel Great Court 8 Arundel Street
London WC2R 3DT(GB)**

(84) Designated Contracting States:
**GB**

(71) Applicant: **N.V. Philips' Gloeilampenfabrieken
Groenewoudseweg 1
NL-5621 BA Eindhoven(NL)**

(84) Designated Contracting States:
**DE FR IT SE**

(72) Inventor: **Smollett, Max
Mullard Limited New Road
Mitcham Surrey CR4 4XY(GB)**

(72) Inventor: **MacDonald, George Leslie
Mullard Limited New Road
Mitcham Surrey CR4 4XY(GB)**

(74) Representative: **Williamson, Paul Lewis et al,
Philips Electronic And Associated Industries Limited
Patent Department Mullard House Torrington Place
London WC1E 7HD(GB)**

(54) Electron beam addressed memory.

(57) An electron beam addressed memory (EBAM) comprising an envelope (10) within which are provided a source of an electron beam, a microcapacitor target (18) and means (24) for receiving, amplifying and detecting a secondary electron beam produced in response to scanning the target (18) by the electron beam in the read mode. In previous designs of EBAMs tungsten filaments or despenser cathodes have been used for producing the electron beam but if these are replaced by a cold semiconductor cathode (12) it is possible to obtain an electron beam of small cross-sectional size, having a high current density and can be switched on and off at frequencies up to at least 30MHz. The means for receiving, amplifying and detecting the secondary electrons produced in the reading operation comprises in the embodiment illustrated an annular microchannel plate electron multiplier (24) disposed about, and coplanarly with, the target (18).

Fig. 9.

EP 0 224 314 A2

## Electron Beam Addressed Memory

The present invention relates to electron beam addressed memories (EBAMs), having a structured target comprising an array of isolated microcapacitors, otherwise known as a mucap target.

EBAMs having mucap targets are well known and are discussed in United States Patent Specifications 3398317 and 3500112 and by John Kelly in a chapter entitled "Recent Advances in Electron Beam Addressed Memories", particularly pages 60 to 81, of a book "Advances in Electronics and Electron Physics" edited by L. Marton, 43, 1977 published by Academy Press N.Y. Generally an EBAM with a mucap target is essentially a vacuum device having an envelope in which is provided an electron gun at one end and a storage mosaic at the other end. Means are provided for scanning the storage mosaic with an electron beam derived from the electron gun both in the write and read modes of operation. The read mode relies on variations in the production of secondary electrons at addressed locations of the mosaic. These secondary electrons are directed towards a band pass filter which is followed by a single channel electron multiplier. The storage mosaic comprises a substrate on which a dielectric layer is formed. A metal layer is disposed on the dielectric layer. A plurality of spaced holes are provided, each of which extends through the metal layer, and partially through the dielectric layer. By deposition of a metal layer into each hole, electrically isolated from the metal layer on the full thickness dielectric, an array of microcapacitors is formed. The electron guns used in these known EBAMs have either a thermionic cathode or a dispenser cathode. Either type of cathode although stable in operation and having adequate lifetime does require complicated electron optics to provide a suitably small, focussed electron beam.

Objects of this invention are to simplify the electron optics and the secondary electron detection to such an extent that high capacity EBAMs can be produced which operate reliably at speeds faster than are obtained when using thermionic or dispenser cathodes.

0224314
PHB33228

According to the present invention there is provided an electron beam addressed memory comprising an envelope within which there is provided at least one semiconductor cold cathode, a target comprising a mosaic of microcapacitors, means for focussing an electron beam produced by the cathode or cathodes, means for deflecting said electron beam(s) onto said target, and means for deflecting, receiving, amplifying and detecting secondary electrons produced by the target in response to the target being scanned by the electron beam(s) when in the read mode.

By using a cold semiconductor type of cathode one is able to provide a switchable/deflectable electron beam of smaller initial diameter than most normal cathodes, more stable than field emission cathodes, and having a high current density. The cathode can be switched on and off at high frequencies permitting thereby fast access time and increased signal to noise ratio during reading. It is of small size, cold and has a low power consumption. Furthermore such cathodes can be manufactured in an array with each one being individually addressable and as the electron beam spot is of substantially the right size, of the order of 1 micron, then any demagnification of the beam is slight and not only does this lead to simplicity in the electron optics but also to a general reduction in aberrations.

The semiconductor cold cathode may comprise a semiconductor body with a p-n junction formed by a p-type region which is covered by an n-type region adjacent to the surface of the semiconductor body, an apertured electrically insulating layer disposed on said surface and an apertured accelerating electrode provided on the insulating layer. In operation reverse biasing the p-n junction causes electrons to emanate from the semiconductor body through the aperture(s) in the insulating layer and accelerating electrode.

In one embodiment the target comprises a substrate of silicon on which a layer of silicon oxide is provided. An aluminium layer is sputtered onto the silicon oxide. A plurality of spaced holes is provided by etching each hole so that it extends through the sputtered aluminium layer and partially through the silicon oxide layer, the exposed silicon oxide in the bottom of these holes and the free surface of the sputtered aluminium layer being covered by an evaporated layer of aluminium. The aluminium layer does not extend along the side walls of the holes, thus ensuring that there are no short circuits between the evaporated aluminium layer at the bottom of the respective holes and the sputtered aluminium layer. The use of aluminium is cheaper than platinum and other metals which have been mentioned in the prior art. Aluminium is also covered by a thin layer of aluminium oxide which provides a higher secondary electron emission coefficient than platinum, is less affected by contamination and has a long life even under electron bombardment in high vacuum.

If desired the evaporated aluminium layer at the bottom of each of the holes may comprise a combination of magnesium oxide and aluminium oxide which has an even higher secondary electron emission coefficient than aluminium oxide.

If desired a silicon nitride layer may be provided on the silicon oxide layer, before the sputtered aluminium layer, silicon nitride being advantageous from the point of view of etching the holes in the oxide, and of providing additional isolation for the microcapacitors.

The means for receiving and amplifying the secondary electrons produced by the target in the read mode may comprise a microchannel plate electron multiplier. By providing an annular microchannel plate electron multiplier which is arranged symmetrically with respect to and coplanar with the target, the electron multiplier has little or no effect on the focussing and scanning fields. Also it increases the efficiency of the electron detection compared to using an asymmetrically arranged single channel electron multiplier which has a small solid angle of collection. In addition it improves the signal to noise ratio because back scattered electrons from the target which are present from both the zero and the one state are not detected.

The present invention will now be described, by way of example, with reference to the accompanying drawings, wherein:

Figure 1 is a diagrammatic cross sectional view through an electromagnetically deflected EBAM made in accordance with the present invention,

Figure 2 illustrates an enlarged portion of the cathode,

Figure 3 is a diagrammatic view of an embodiment of a mucap target structure,

Figures 4 and 5 are diagrams illustrating the operation of writing a ZERO and writing a ONE, respectively, on the target.

Figures 6 and 7 are diagrams illustrating the essential differences between a ZERO and a ONE respectively,

Figure 8 is a diagrammatic view through a second, electrostatically deflected, EBAM made in accordance with the present invention,

Figure 9 is a longitudinal view, partly in cross section, through a third, electromagnetically deflected, EBAM made in accordance with the present invention,

Figure 10 is a cross-sectional view of the tube only taken on the line $\overline{X} - \overline{X}$ of Figure 9, and

Figures 11 and 12 are computer plots of simulations of the secondary electron trajectories when reading a ONE and a ZERO respectively. As is customary these computer plots only illustrate half the diametric thickness of the EBAM, the non-illustrated half being assumed to be the same.

In the drawings the same reference numerals have been used to indicate corresponding parts.

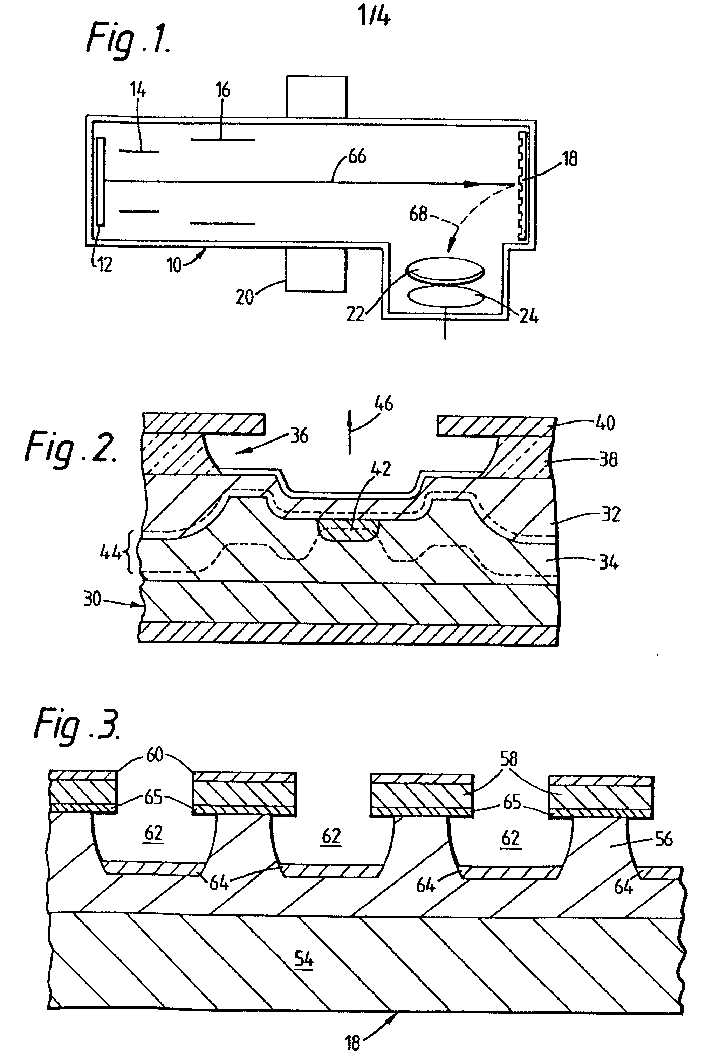

Referring to Figure 1 the EBAM shown comprises an evacuated envelope 10 in which there are provided a solid state, semiconductor cold cathode structure 12, a pair of cylindrical electrodes 14 and 16 for focussing an electron beam produced by the cathode structure 12 and a mucap type target structure 18 arranged at the opposite end of the envelope to the cathode 12. Electromagnetic means 20 are disposed about the envelope 10 for deflecting randomly or sequentially the electron beam derived from the cathode structure 12 across the target 18. Information is stored in binary form on the microcapacitors formed in the target 18 and this information is non-destructively read by scanning the target with an electron beam of lower current than the write beam and thereby causing secondary electrons to be produced by the target. Some of these secondary electrons are collected and amplified by a microchannel plate electron multiplier represented at 22 and the output from the channels of the multiplier is directed to a collector electrode 24, which may be an integral part of the electron multiplier, which produces an appropriate signal output. Discrimination between ONE and ZERO is achieved, not directly by voltage contrast as is done in known EBAMS but by the fact that many more electrons reach the multiplier from a ONE than from a ZERO. The cathode structure 12 may be a structure of the type described and claimed in British Patent Specification 2054959B (PHN 9532), details of which are incorporated by way of reference.

Figure 2 shows one type of cathode structure 12, which structure comprises a semiconductor body 30 with a p-n junction formed between an n-type region 32 adjoining the surface of the semiconductor body 30 and an underlying p-type region 34.

An electrically insulating layer 38 is provided on the n-type region 32 and an accelerating electrode 40 is provided on the layer 38. At least one aperture 36 is etched through the layer 38 using the electrode 40 as a mask.

The p-n junction at least within the aperture extends substantially parallel to the surface and within the aperture has a region 42 of lower break-down voltage than the remaining part of the p-n junction. The region 42 having a lower breakdown voltage is separated from the surface by the n-type conductive layer 32 which has such a thickness and doping concentration that at the lower break-down voltage the depletion zone 44 of the p-n junction does not extend up to the surface but remains separated therefrom by a surface layer which is sufficiently thin to pass the generated electrons.

In operation electrons are generated in the semiconductor body by avalanche multiplication in response to applying a voltage in the reverse direction across the p-n junction via an electrode (not shown) connected to the n-type region 32 and an electrode on the lower face of the body. The electrons emanate from the semiconductor surface through the aperture 36 and are accelerated by the voltage on the accelerating electrode 40. The electron beam emerging in the direction 46 through the aperture 36 has a high current density and small cross-sectional area. Depending on the size of the mucaps then the electron lens formed by the cylinders 14, 16 may require only a slight demagnification to obtain a spot of the right size, of the order of 1 micron, at the target 18. For a further description of the cathode structure and its operation, reference is invited to British Patent Specification 2054959.

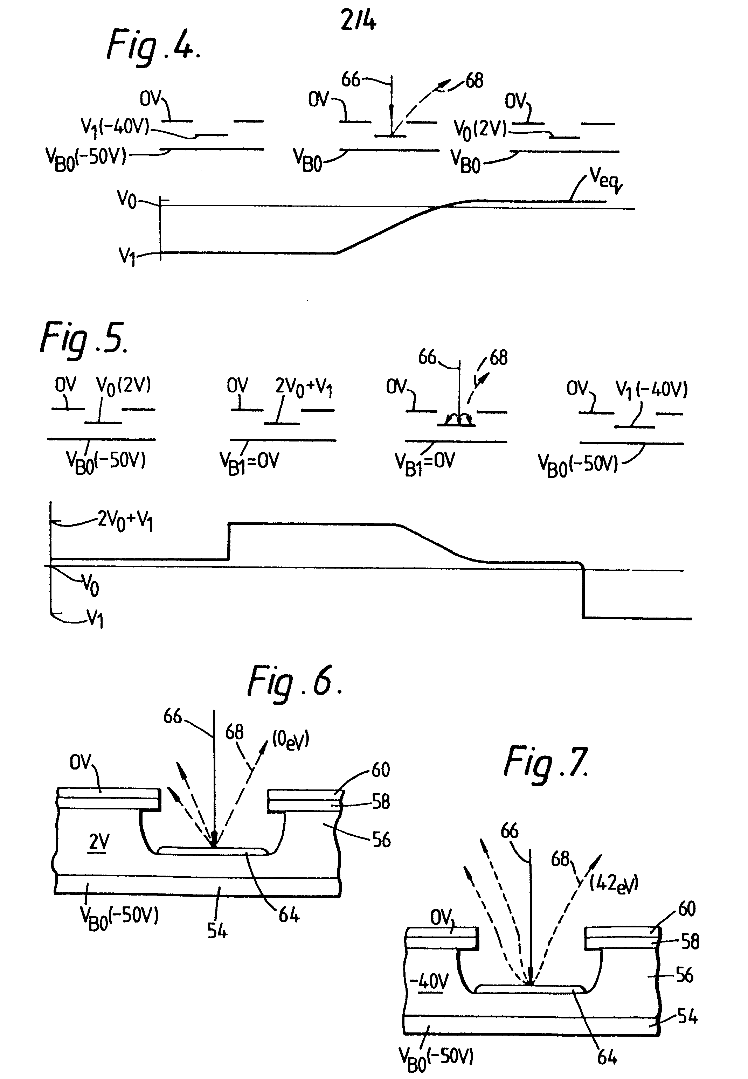

Figure 3 shows an example of a target 18 in greater detail. The target 18 comprises a layer 54 of low resistivity silicon onto which a layer 56 of silicon oxide is deposited. The thickness of the layer 56 can be, for example, of the order of 1.5 microns. A layer 58 of aluminium is sputtered onto the free surface of the silicon oxide in such a manner as to form an array of holes in the aluminium. Using the sputtered aluminium layer as a mask, the layer 56 is etched to provide a plurality of holes 62 which extend only part way through the layer. Lateral etching of the holes 62 takes place so that the layer 58 is undercut. A predetermined thickness of silicon oxide for example 0.3 microns, is left between the bottom of each hole and the interface with the silicon layer 54. An evaporated aluminium layer 60 is provided on top of the sputtered aluminium 58 and simultaneously the aluminium layer 64 is provided in the bottom of each hole. Each of these layers 64 together with the silicon layer 54 and the intervening layers of silicon oxide form microcapacitors in which charge can be stored. In selecting the types of material for the layer 64 these should have a good secondary electron emission coefficient and although aluminium layers are provided, the surface of these oxidizes naturally in air to aluminum oxide to provide a stable surface having a secondary electron emission coefficient greater than one and usually between 2 and 3. Other types of layers can be used and in particular a combination of magnesium and aluminium oxides, for

0224314

example as disclosed in British Patent Specification 2048561B (PHB32649X). The diameter of the holes can be as small as advancing silicon technology allows. Optionally a silicon nitride layer 65 may be disposed on the silicon oxide layer and the aluminium layer 58 is sputtered onto the layer 65. The presence of the silicon nitride layer 65 assists in the etching process, and in isolating the microcapacitors.

In the operation of the EBAM shown in Figure 1 the write electron beam has an energy of the order of 2keV. The low resistivity silicon layer 54 (Figure 3) may be regarded as being a base and reference will be made to base potential whilst the combined aluminium layers 60 and 58 (Figure 3) will be referred to as the gate. The base potential determines the final mucap potential because the mucap is more closely coupled capacitatively to the base than to the gate. The ONE state corresponds to a negative stored charge with respect to the gate and a ZERO state corresponds to a small positive charge.

Figure 4 illustrates the writing of a ZERO and the cycle begins at the left hand side by initially producing a ONE state condition. This is done by the application of negative bias $V_{BO}$ (typically minus 50 volts) to the base which causes the uncharged mucaps to be sent to a negative value $V_1$ (typically minus 40 volts). The write ZERO sequence continues as shown in the middle of Figure 4. The negatively charged mucap which has a surface with a secondary electron emission coefficient greater than unity is bombarded by an electron beam 66 which charges the target positively until it stabilises at $V_{eq}$ which is just a few volts positive with respect to the gate potential $V_0$. $V_{eq}$ in consequence represents the ZERO state.

Figure 5 shows the writing of a ONE commencing from a ZERO state. The first step is to switch the base potential to $V_{B1}$ (zero volts). This causes ZERO state elements at $V_0$ (approximately 2V) to become switched more positive by $V_0 + V_1$ to be at $2V_0 + V_1$. The electron beam 66 is then turned on and, because the mucaps are positive, charge is collected until the stable potential of $V_0$

(approximately 2 volts) is reached as before. At this point, the beam is removed and the base potential is switched back to $V_{BO}$ (minus 50 volts). In consequence the voltage on the mucaps returns to $V_1$ (minus 40 volts) which signifies the ONE state.

In order to read out non-destructively the stored information, the target is scanned, sequentially or randomly, by a lower current beam from the cathode 12 than is used in writing. In response to the read beam, the energy of the true secondary electrons emitted from the mucaps as opposed to the backscattered electrons depends on their state of charge. Figure 6 illustrates reading-out of a ZERO. The electrode 64 is at say +2V and the true secondary electrons 68 emerging through the apertured gate electrode are relatively few in number and have a low energy (0eV) and can be made to return to the gate by providing in the vicinity a low energy negative field. Alternatively in reading out a ONE state, Figure 7, the electrode 64 is at say -40V and the secondary electrons 68 have a higher energy (42eV) than the ZERO state and many more of them escape from the target. Thus by capturing the secondary electrons emitted and determining their number a decision can be made as to whether the information represents the binary ONE or binary ZERO. In the illustrated embodiment, Figure 1, some of the secondary electrons 68 emitted are collected and amplified using the channel electron multiplier 22 and are then directed towards the collector electrode 24.

The charge stored on a mucap will diminish with time and with the number of times a read-out has occurred. Accordingly an infrequent refresh cycle using a beam produced by the cathode 12 is used.

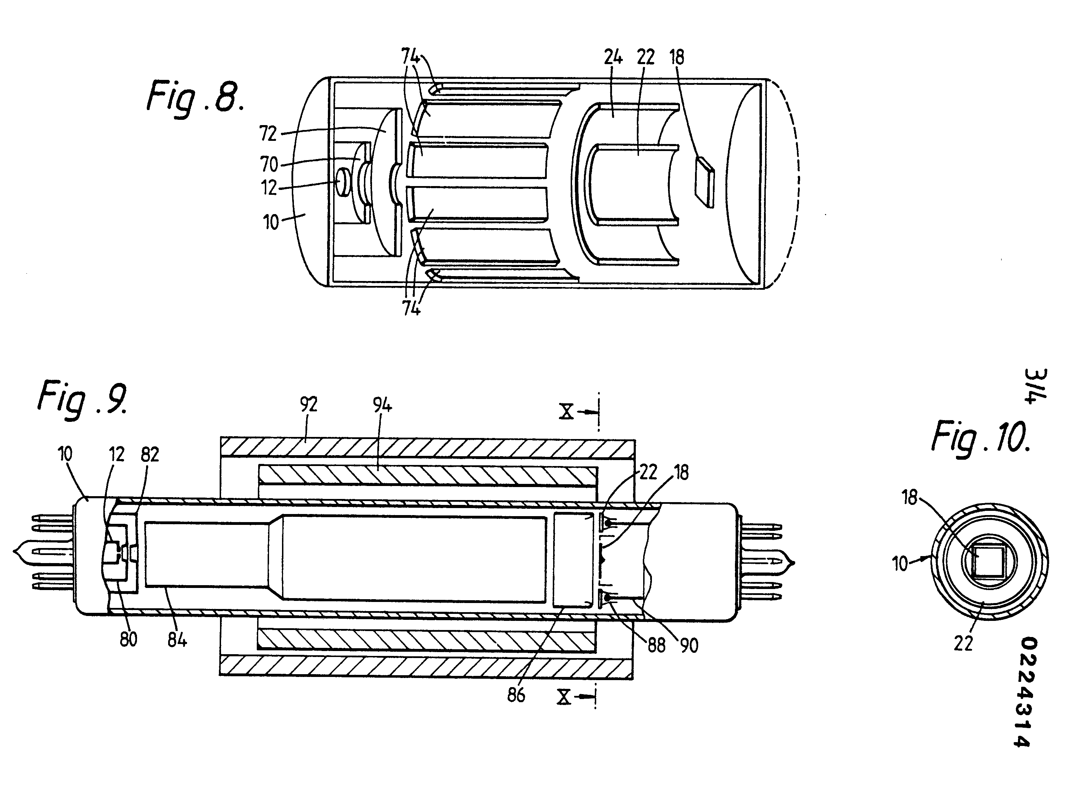

The embodiment in Figure 8 comprises a generally cylindrical, hermetically sealed glass envelope 10 having a cold cathode emitter 12 at one end and a mucap target 18 at the opposite end. The focusing lens electrodes 70, 72 are generally of annular form having an aperture which is coaxial with the axis of the envelope. A plurality of pairs of oppositely disposed electrodes 74, provided around the interior cylindrical surface of the envelope 10 enable a multipole electrostatic field to be created for deflecting the electron beam from the cathode 12 across the input face of the target 18. A microchannel plate electron multiplier 22 having thousands of channels (apertures) extending therethrough and of cylindrical form is disposed about the axis of the envelope such that its channels extend generally radially and is surrounded by a cylindrical collector electrode 24. It will be appreciated that only half of the multiplier 22, the collector electrode 24, the electrodes 70 and 72 and the array of electrodes 74 are visible in the sectional view shown in Figure 8.

This concentric arrangement of the electron multiplier 22 and the collector electrode 24 is regarded as being more efficient than the arrangement shown in Figure 1.

As the principle of operation of the tube is substantially identical to that as described already it will not be repeated.

Figures 9 and 10 show a practical embodiment of an electromagnetically deflected EBAM. The EBAM comprises a cylindrical, hermetically sealed envelope 10 of circular cross section. Arranged along and substantially co-axially about the longitudinal axis of the envelope 10 are a cold cathode emitter 12, (or alternatively an array of such emitters) first and second annular grids 80, 82, respectively, a cylindrically shaped third grid 84, a cylindrical fourth grid 86, an annular microchannel plate electron multiplier 22 arranged with its channels extending axially of the envelope and a mucap target 18 coplanarly arranged with the microchannel plate. A Faraday cage 88 is provided around the output side of the electron multiplier 22 and a low capacitance signal collector ring 90 is disposed in the Faraday cage 88 at a position to collect electrons emerging from the electron multiplier 22. Around the outside of the envelope 10 are disposed concentrically a focusing coil 92 and horizontal and vertical deflection coils 94.

In operation the following voltages for example may be applied which are related to the gate voltage of the EBAM being taken as -1400V:-

Cathode -3400V

3rd Grid 84 -1600V

4th Grid 86 -1450V

Base voltage of EBAM -1450V

Input voltage of electron multiplier -1300V

Output voltage of electron multiplier -100V

Signal collector ring 90 0V.

The electron beam produced by the cold cathode(s) 12 has its beam current controlled by the voltage on the first grid 80. The voltage on the second grid 82 accelerates the beam which passes through the cylindrically shaped third and fourth grids 84, 86, respectively. Any focussing of the electron beam is carried out adjusting one or both of the voltage applied to the third grid 84 and the current through the focussing coil 92. Electromagnetic scanning of the beam is effected by varying the current in the coils 94.

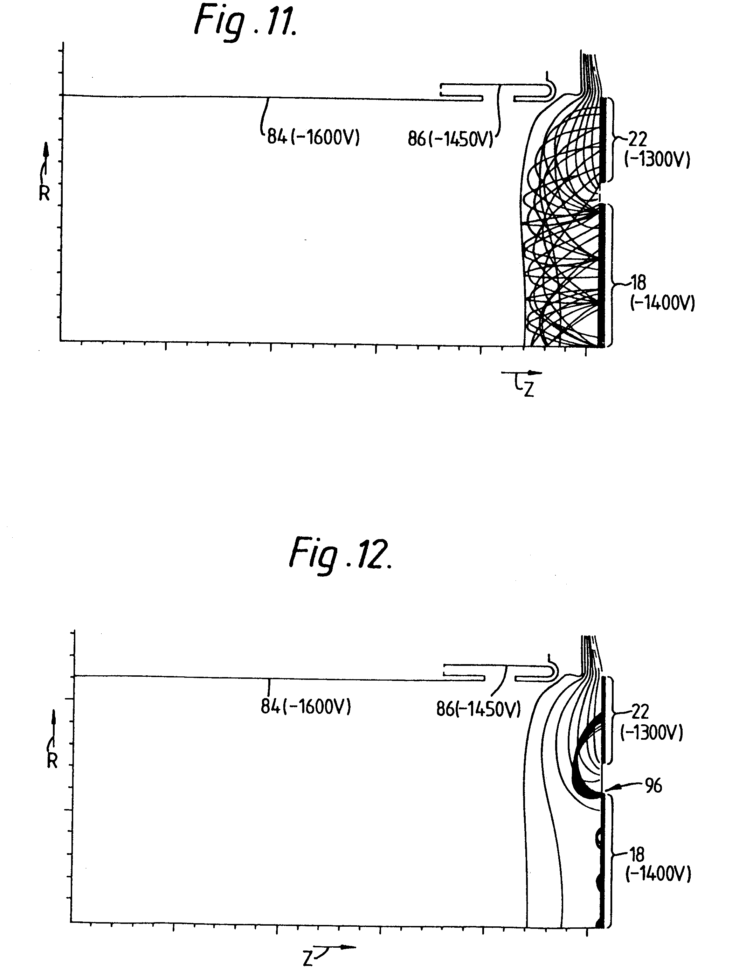

In the read mode for a stored binary ONE the true secondary electrons produced by the mucap target are reflected by the electrostatic field formed by the third grid 84, the fourth grid 86 and the gate of the EBAM and follow trajectories either back to the gate electrode of the target 18 or towards the more positive input surface of the electron multiplier 22. This is illustrated in the computer plot shown in Figure 11. The current multiplied electrons emerging from the output of the multiplier 24 are collected by the electrode 90. In contrast, for a binary ZERO stored on the mucap target 18, the secondary electrons produced during reading have such a low energy that the majority, if not all, are reflected back into the surface of the target 18. This is illustrated in Figure 12. Although a pronounced stream of secondary electrons originating from the point 96 is shown, this represents the effect of a corner of a square target surrounded by circular electron multiplier 22 and in reality steps would be taken to eliminate this problem or to make its effect negligible. Because of the coplanar positions of the target and microchannel plate electron multiplier higher energy backscattered electrons, which emerge from all adressed mucaps, cannot be detected. Therefore merely detecting the number of secondary electrons reaching the input of the electron multiplier 22 is a reliable indication of whether a binary ONE or ZERO is being stored.

In the illustrated embodiments of the EBAMs the cathode may comprise a matrix of say 3 x 3 or 4 x 4 emitters. Switching of the electron beam takes place at the cathode or at the first grid. Since the switching is fast then this enables the illustrated EBAMs to effect vector scanning of the target which entails switching on the cathode on reaching the desired location on the target.

CLAIMS

1.  An electron beam addressed memory comprising an envelope within which there is provided a semiconductor cold cathode, a target comprising a mosaic of microcapacitors, means for focusing an electron beam produced by the cathode, means for deflecting said electron beam across said target, and means for deflecting, receiving, amplifying and detecting secondary electrons produced by the target in response to the target being scanned by the electron beam when in the read mode.

2.  A memory as claimed in Claim 1, wherein the semiconductor cold cathode comprises a semiconductor body with a p-n junction formed by an n-type region adjacent to the surface of the semiconductor body and a p-type region, an apertured electrically insulating layer on said surface and an apertured accelerating electrode on the insulating layer, whereby reverse biasing the p-n junction causes electrons to emanate from the semiconductor surface through the aperture(s) in the insulating layer and accelerating electrode.

3.  A memory as claimed in Claim 2, wherein the cathode comprises a matrix of p-n junctions.

4.  A memory as claimed in Claim 1, 2 or 3, wherein the target comprises a substrate of silicon, a layer of silicon oxide on the substrate, a layer of sputtered aluminium on the silicon oxide, a mosaic of apertures extending through the sputtered aluminium layer and into the silicon oxide layer for a predetermined depth, a layer of evaporated aluminium on the sputtered aluminium layer and a layer of a secondary electron emitting material covering the bottoms of the apertures in the silicon oxide layer.

5.  A memory as claimed in Claim 4, wherein a layer of silicon nitride is disposed between the layer of silicon oxide and the layer of sputtered aluminium.

6.  A memory as claimed in Claim 4 or 5, wherein the secondary electron emitting material is aluminium oxide.

7.  A memory as claimed in Claim 4 or 5, wherein the secondary electron emitting material comprises a combination of magnesium oxide and aluminium oxide.

8.   A memory as claimed in any one of Claims 1 to 7, wherein the means for receiving and amplifying said secondary electrons comprises a microchannel plate electron multiplier.

9.   A memory as claimed in any one of Claims 1 to 7, wherein the means for receiving, amplifying and detecting said secondary electrons comprises a cylindrical microchannel plate electron multiplier disposed within a cylindrical detector.

10.   A memory as claimed in any one of Claims 1 to 7, wherein the means for receiving and amplifying said secondary electrons comprises an annular microchannel plate electron multiplier mounted about, and coplanarly with, the target.

11.   A memory as claimed in Claim 10, wherein a collector ring is disposed adjacent the output side of the annular microchannel plate electron multiplier for collecting output electrons therefrom.

Fig .1.

Fig .2.

Fig .3.

*Fig.4.*

214

66 68

0V
0V
0V
$V_1(-40V)$
$V_0(2V)$
$V_{B0}(-50V)$
$V_{B0}$
$V_{B0}$

$V_0$
$V_{eq}$
$V_1$

*Fig.5.*

0V $V_0(2V)$
0V $2V_0+V_1$
0V
66 68
0V $V_1(-40V)$

$V_{B0}(-50V)$
$V_{B1}=0V$
$V_{B1}=0V$
$V_{B0}(-50V)$

$2V_0+V_1$
$V_0$
$V_1$

*Fig.6.*

66 68 (0eV)

0V 60
58
2V 56

$V_{B0}(-50V)$ 54 64

*Fig.7.*

66 68 (42eV)

0V 60
58
-40V 56
54

$V_{B0}(-50V)$ 64

Fig. 8.

Fig. 9.

Fig. 10.

# Fig .11.

84 (-1600V)    86 (-1450V)    22 (-1300V)    18 (-1400V)

R

Z

# Fig .12.

84 (-1600V)    86 (-1450V)    22 (-1300V)    96    18 (-1400V)

R

Z

4-IV-PHB 33228